(19) Europäisches Patentamt
European Patent Office
Office européen des brevets

(11) EP 1 187 184 A2

(12) # EUROPEAN PATENT APPLICATION

(43) Date of publication:
**13.03.2002 Bulletin 2002/11**

(51) Int Cl.$^7$: **H01L 21/02**, H01G 4/00

(21) Application number: **01306985.1**

(22) Date of filing: **17.08.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **30.08.2000 JP 2000266016**
**26.09.2000 JP 2000297084**

(71) Applicant: **ALPS ELECTRIC CO., LTD.**
**Ota-ku Tokyo 145 (JP)**

(72) Inventors:
- **Kitagawa, Hitoshi, Alps Electric Co., Ltd.**
  **Tokyo 145 (JP)**
- **Sasaki, Makoto, Alps Electric Co., Ltd.**
  **Tokyo 145 (JP)**
- **Sasaki, Yorihiko, Alps Electric Co., Ltd.**
  **Tokyo 145 (JP)**

(74) Representative: **Enskat, Michael Antony Frank**
**Saunders & Dolleymore,**
**9, Rickmansworth Road**
**Watford, Hertfordshire WD18 0JU (GB)**

(54) **Thin film capacitor for temperature compensation**

(57) A thin film capacitor with an arbitrary temperature coefficient of capacitance can be obtained by using only two kinds of dielectric thin film capacitor, wherein the dielectric thin film (3) having a prescribed temperature coefficient of capacitance is formed on the surface of a lower electrode (2) formed on a substrate (1), a second dielectric film (4) having a different temperature coefficient of capacitance from the temperature coefficient of capacitance of the prescribed temperature coefficient of capacitance is formed so as to cover from the upper edge of the dielectric thin film to the step portion of the dielectric thin film, and an upper electrode (5) is formed so as to cover the dielectric thin film and second dielectric film, and wherein the temperature coefficient of capacitance is determined by adjusting the overlap area of the lower electrode and upper electrode between the lower electrode and upper electrode.

FIG. 1

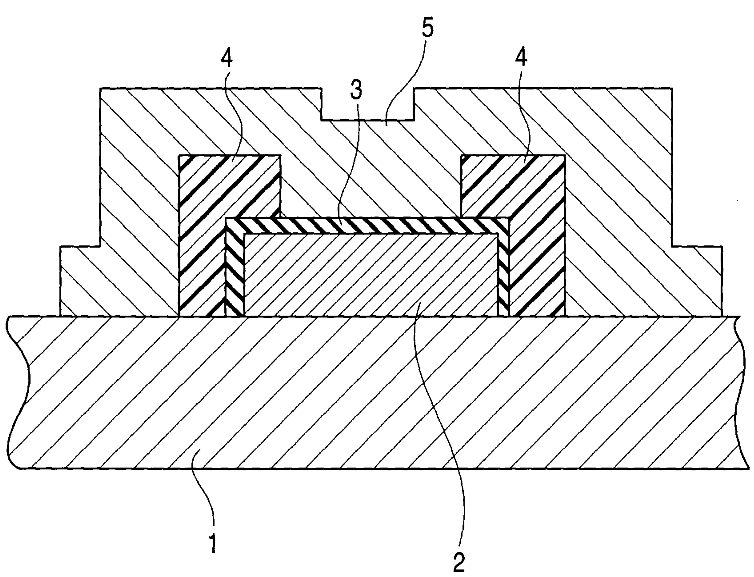


EP 1 187 184 A2

## Description

BACKGROUND OF THE INVENTION

1. Field of the Invention

The present invention relates to a thin film capacitor for temperature compensation by which temperature dependency of an entire electronic circuit is reduced by compensating temperature dependency of junction capacitance of semiconductor elements in an electronic circuit.

2. Description of the Related Art

The thin film capacitor generally has a structure manufactured by laminating a lower electrode, a dielectric layer and an upper electrode on a substrate or, in some cases, a structure manufactured by sequentially laminating the dielectric layer and upper electrode on a semiconductor substrate that functions as a lower electrode.

For widely selecting temperature coefficients of capacitance in the conventional thin film capacitor of this class, a dielectric material having a temperature coefficient of capacitance close to the desired temperature coefficient of capacitance has been searched for using it in the dielectric layer.

However, since the dielectric layer is required to have a thickness of 0.5 μm or less in small size thin film capacitors, it has been difficult to prepare a dielectric material that satisfies various conditions required for the thin film capacitor, for example the temperature coefficient of capacitance as well as film deposition conditions, relative dielectric constant and withstand voltage. Therefore, the dielectric materials having the practically available temperature coefficient of capacitance can be only selected from a restricted range.

A thin film capacitor comprising a second dielectric film at the end of the dielectric material has been known in the art as a thin film capacitor in which only the withstand voltage at the end of the dielectric material of the thin film capacitor is improved.

However, since the capacitor comprising the second dielectric film has a structure for the purpose of always improving the withstand voltage at the end of the dielectric material, the temperature coefficient of capacitance is not necessarily controlled. Consequently, the problem of preparing a variety of dielectric materials has not been solved yet.

SUMMARY OF THE INVENTION

Accordingly, it is an object of the present invention for solving the foregoing problems to make it easy to provide a thin film capacitor having an arbitrary temperature coefficient of capacitance using only two kinds of dielectric thin film materials.

The present invention for solving the problems as hitherto described provides a thin film capacitor for temperature compensation comprising a lower electrode formed on a substrate, a dielectric thin film pattern formed on the lower electrode and having a prescribed temperature coefficient of capacitance, a second dielectric film having a temperature coefficient of capacitance being different from the prescribed temperature coefficient of capacitance, and an upper electrode provided at above the dielectric thin-film pattern so as to face the lower electrode. The second dielectric film is provided so as to cover the step portion from the edge of the upper face of the dielectric thin film pattern to the side face of the lower electrode, or so as to cover from the edge of the upper face of the dielectric thin film pattern to the side face of the dielectric thin film pattern. The temperature coefficient of capacitance is defined by adjusting the area comprising only the region of the dielectric thin film pattern between the lower electrode and upper electrode, and the area of the overlap region between the dielectric thin film pattern and second dielectric film.

A capacitor portion (a capacitor 51) formed with the region only comprising the dielectric thin film, and a capacitor portion (a capacitor 52) comprising the two layers of the dielectric thin film and the second dielectric film are connected in parallel with each other between the lower electrode and upper electrode. In addition, the capacitor 51 has a different temperature coefficient of capacitance from that of the capacitor 52.

Accordingly, a thin film capacitor for temperature compensation having an arbitrary temperature coefficient of capacitance may be readily available without preparing various kinds of the dielectric thin film materials, when the temperature coefficient of capacitance is defined by adjusting the areas of the capacitor 51 region and capacitor 52 region.

Providing the second dielectric material relaxes the restrictions of withstand voltage characteristics for the step portion of the dielectric thin film covering the edge of the electrode, or the side face of the electrode, or at the side face of the dielectric thin film.

Preferably, the dielectric thin film has a temperature coefficient of capacitance with an absolute value of 50 ppm/°C or less, and the second dielectric film has a negative temperature coefficient of capacitance with an absolute

value of 500 ppm/°C or more.

It is made possible to adjust the temperature coefficient of capacitance of the thin film capacitor, or to make temperature compensation, merely by adjusting the overlap area between the second dielectric film and dielectric thin film when the dielectric thin film having the temperature coefficient within the range described above is used.

Desirably, the second dielectric film has a relative dielectric constant of 4 or less, and a linear thermal expansion coefficient of 50 ppm/°C. Electronic polarization is mainly responsible for polarization of the dielectric material having a relative dielectric constant of 4 or less. The temperature coefficient of capacitance is negative in this case, and the absolute value is proportional to the linear thermal expansion coefficient. Accordingly, a temperature coefficient of capacitance with a negative and larger absolute value may be available when the relative dielectric constant is 4 or less and the linear thermal expansion coefficient is larger.

A negative temperature coefficient of capacitance with an absolute value of 500 ppm/°C may be obtained by forming a dielectric film having the characteristics as described above.

The withstand voltage of the dielectric material in the vicinity of the end of the electrode usually becomes lower than that on the flat portion when the dielectric material covers from the end of the electrode to the side face of the electrode, due to convergence of the electric field and deterioration of the film quality of the dielectric material on the upper end of the electrode. This withstand voltage is referred as the withstand voltage at the end of the electrode. When the second dielectric film is laminated on the dielectric thin film covering the end of the electrode with a planar withstand voltage of the dielectric thin film of 100V or more and the withstand voltage of the second dielectric film at the end of the electrode of 100V or more, a thin film capacitor with the withstand voltage at the end of the electrode of 100V or more can be formed, and the capacitor may be used for high performance electronic components.

Also, the Q-value of the thin film capacitor at 1 GHz becomes 100 or more to enable the capacitor to be used for high frequency electronic components, by forming the dielectric thin film having a Q-value of 200 or more, and the second dielectric film having a Q-value of 10 or more at a frequency of 1 GHz.

The dielectric thin film with a thickness of 0.5 μm or less and having the planar withstand voltage of 100V or more, the Q-value at a frequency of 1 GHz of 200 or more, and the absolute value of the temperature coefficient of capacitance of 50 ppm/°C or less can be readily obtained by using $SiO_xN_y$ as the dielectric thin film.

The second dielectric film having the withstand voltage at the end of the electrode of 100V or more, the Q-value at the frequency of 1 GHz of 10 or more, and the negative temperature coefficient of capacitance with an absolute value of 500 ppm/°C or less can be readily obtained by using an acrylic resin or a fluorinated resin as the second dielectric film.

An acrylic polymer material containing a cured product of a copolymer of an alkyl acrylate with glycidyl methacrylate may be favorably used as the acrylic resin.

An amorphous fluorinated resin (a resin with the trade name of CYTOP made by Asahi Glass Co.) may be favorably used as the fluorinated resin.

The thin film capacitor with the planar withstand voltage of 100V or more, the Q-value at a frequency of 1 GHz of 100 or more, and the negative temperature coefficient of capacitance with an arbitrary absolute value may be easily obtained by using $SiO_xN_y$ as the dielectric thin film and an acrylic resin or a fluorinated resin as the second dielectric film.

An embodiment of the present invention will now be described, by way of example, with reference to the accompanying diagrammatic drawings, in which:

Fig. 1 shows a cross section of the thin film capacitor according to the first embodiment;
Fig. 2 shows a plane view of the thin film capacitor shown in Fig. 1;
Fig. 3 illustrates the function of the thin film capacitor shown in Fig. 1;
Fig. 4 shows an equivalent circuit diagram of the thin film capacitor shown in Fig. 1;
Fig. 5 shows a cross section of the thin film capacitor according to the second embodiment;
Fig. 6 shows a plane view of the thin film capacitor shown in Fig. 5; and
Fig. 7 an equivalent circuit diagram of the thin film capacitor shown in Fig. 5.

## DESCRIPTION OF THE PREFERRED EMBODIMENTS

While the present invention is described hereinafter with reference to embodiments, the present invention is by no means restricted by the embodiments as set forth hereinafter.

Figs. 1 to 4 shows the thin film capacitor in a first embodiment of the present invention comprising a thin film of a first electrode layer (lower electrode) 2 formed on one face of a substrate 1, and a pattern of a dielectric thin film 3 formed thereon so as to cover the lower electrode 2. Subsequently, a second dielectric film 4 is laminated so as to cover the both ends of the lower electrode 2 and dielectric thin film 3, followed by forming a second electrode (upper electrode) 5 so as to cover the lower electrode 2, dielectric thin film 3 and second dielectric film 4.

The material of the substrate 1, though not in particular restrictive, may have a thickness enough for endowing the entire capacitor with an appropriate rigidity while being able to withstand the film deposition temperature when thin films of the lower electrode layer 2, dielectric thin film 3, second dielectric film 4 and upper electrode layer 5 are formed by a film deposition method. Examples of the materials that satisfy the conditions above include a silicon wafer whose surface is covered with silicon, as well as $SiO_2$ and $Al_2O_3$.

The lower electrode 2 and upper electrode 5 may have a monolayer structure comprising a pure metal of Cu, Ag, Au or Pt, or may be formed by laminating a plurality of metallic layers. Two or more layers comprising silicon oxide, Cr, Ni, chromium oxide and Pt may be laminated to form a laminated structure.

It is preferable that the dielectric thin layer 3 have a higher Q-value and smaller rate of change of temperature as compared with the second dielectric film 4 to be described hereinafter.

Preferably, the practically used dielectric thin film 3 has an absolute value of the temperature coefficient of capacitance of 50 ppm/°C or less, a relative dielectric constant of 10 or less, a withstand field strength of 5 MV/cm or more, more preferably 8 MV/cm, a Q-value of 200 or more, more preferably 500 or more (at a frequency of 1 GHz), and a dielectric relaxation time of 1 second or more. The dielectric thin film 3 preferably has a thickness of 1 μm ($1 \times 10^{-6}$ m), more preferably in the range of 500 to 5000 Å (0.05 to 0.5 μm), in order to secure a withstand voltage while making the film thin with high productivity.

Examples of the materials satisfying the conditions above include an amorphous $SiO_xN_y$ layer and $SiO_x$ layer. This amorphous $SiO_xN_y$ layer can be formed by a film deposition method such as a PECVD method.

Although the second dielectric film 4 may have a withstand field strength and Q-value a little inferior to those of dielectric thin film 3, the rate of change of temperature is preferably higher than that of the dielectric thin film 3.

The practically used second dielectric film 4 preferably has a negative temperature coefficient of capacitance with an absolute value of 500 ppm/°C or more, a relative dielectric constant of 4 or less, and a Q-value of 10 or more (at 1 GHz).

Examples of the layer that satisfies these conditions include acrylic resin films and fluorinated resin films. The acrylic resin film or the fluorinated resin film has a negative temperature coefficient of capacitance with a high absolute value, and is provided for the purpose of adjusting the temperature coefficient of capacitance of the thin film capacitor. The acrylic resin thin film can be deposited by a conventional semiconductor photolithographic process (comprising such processes as spin coat, pre-bake, exposure, development and firing). The controllable film thickness ranges from 1000Å to several micrometers.

The acrylic resin film is formed by a reaction of methyl polymethacrylate represented by the formula (1) with glycidyl methacrylate represented by the formula (2):

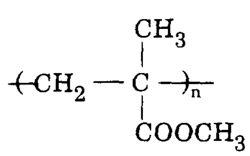

(1)

(in the formula, n is an integer of from 50 to 100)

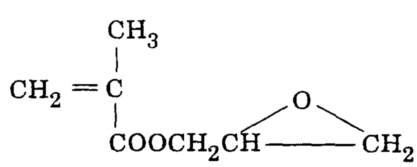

(2)

The resin is desirably a polymethacrylic acid resin having a repeating unit represented by the following formula:

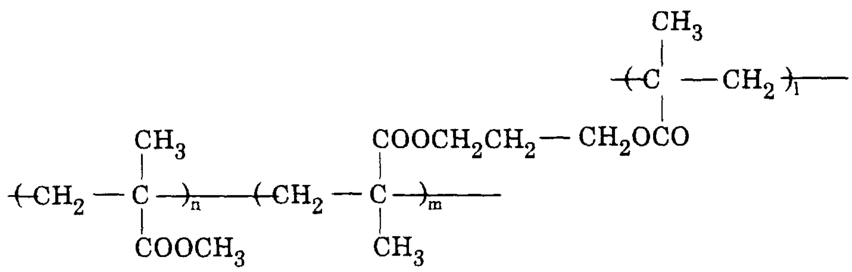

(3)

(in the formula, n, m and 1 represent integers of from 50 to 1000)

The temperature coefficient of capacitance can be controlled in the resin having the structure above by changing the linear thermal expansion coefficient that depends on the polymerization ratio between methyl methacrylate and glycidyl methacrylate. For example, one of the copolymer has a relative dielectric constant of 3.5, a temperature coefficient of capacitance of -2200 ppm/°C, a withstand voltage at the end of the lower electrode (a step height of 3 μm, film thickness of 1 μm) of 100V, a Q-value (at 1 GHz) of 100, and a linear thermal expansion coefficient of 210 ppm/°C.

The acrylic resin film is also formed by a reaction of methyl methacrylate represented by a following formula (4) with glycidyl methacrylate represented by the following formula (5) :

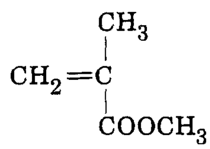

(4)

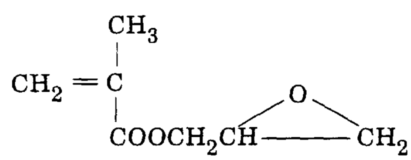

(5)

The resin is desirably a polymethacrylic acid resin having a repeating unit represented by the following formula:

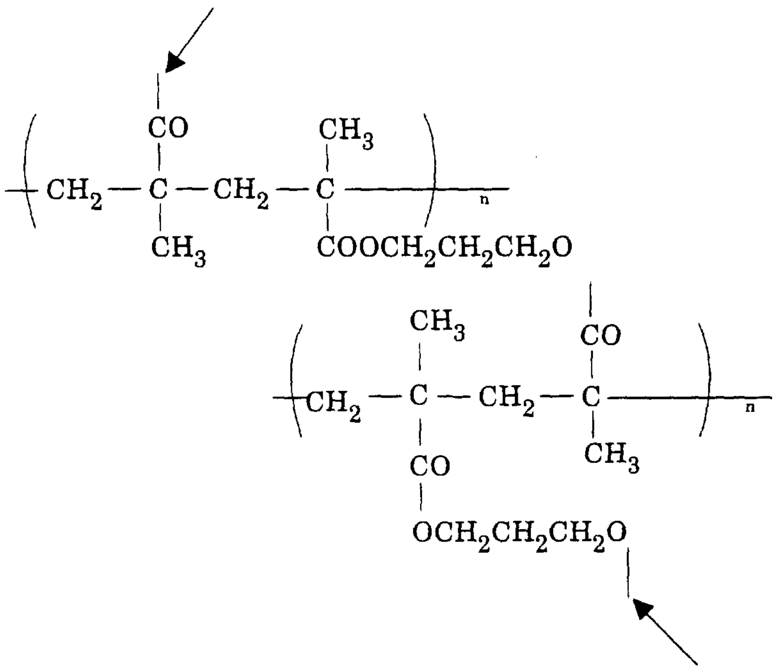

(6)

(in the formula, n represents an integer of from 50 to 1000)

In the formula (6), while the lines shown by the upper and lower arrows represent chemical bonds, their bonding partners are not specified (represent repeating units).

It is possible for the resin having the structure described above to control the temperature coefficient of capacitance by changing the linear thermal expansion coefficient that depends on the polymerization ratio between methyl methacrylate and glycidyl methacrylate. For example, one of the copolymer has a relative dielectric constant of 3.5, a temperature coefficient of capacitance of -2200 ppm/°C, a withstand voltage at the end of the lower electrode (a step height of 3 μm, film thickness of 1 μm) of 100V, a Q-value (at 1 GHz) of 100, and a linear thermal expansion coefficient of 210 ppm/°C.

The desirable fluorinated resin film is made of an amorphous fluorinated resin with a trade name of CYTOP (made by Asahi Glass Co.). This resin film is featured by providing a dielectric material having a high Q-value at high frequency regions. For example, one of the resin film has a relative dielectric constant of 2.1, a temperature coefficient of capacitance of -1000 ppm/°C, a withstand voltage at the end of the lower electrode (a step height of 3 μm, film thickness of 1 μm) of 100V, a Q-value (at 1 GHz) of 1400, and a linear thermal expansion coefficient of 74 ppm/°C.

A capacitor region 51 merely comprising the dielectric thin film 3, and a capacitor region 52 formed by laminating the dielectric thin film 3 and second dielectric film 4 are formed by being connected in parallel with each other.

The capacitor region 52 is equivalent to a capacitor formed by connecting a capacitor 52a comprising a part of the dielectric thin film 3 and a capacitor 52b comprising the second dielectric film 4 in series.

The capacitance C of the capacitor formed between the lower electrode 2 and upper electrode 5 is represented by the following equation I, when the capacitance of each partial capacitor 51, 52a and 52b is represented by C3, C3' and C4, respectively:

$$C = C3 + 1/(1/C3' + 1/C4) \qquad \text{(I)}$$

The temperature coefficient τ of the capacitance C is represented by the following equation II, when the temperature coefficient of capacitance of the dielectric thin film is represented by τ3, and the temperature coefficient of capacitance of the second dielectric film 4 is represented by τ4:

$$\tau = [\tau3(C3 + 1/\{C3'(1/C3' + 1/C4)^2\}) + \tau4/\{C4(1/C3' +$$

$$1/C4)^2\}]/C \quad (II)$$

Accordingly, the temperature coefficient of the capacitance C may be freely determined by the temperature coefficient of capacitance $\tau 4$ of the second dielectric film 4, and by the overlap region between the dielectric thin film 3 and second dielectric film 4.

The planar withstand voltage of the dielectric thin film 3 can be utilized in maximum in the thin film capacitor having the construction as described above, since the step portions at both edges of the dielectric thin film 3 are covered with the second dielectric film 4 for effectively enhancing the withstand voltage of the dielectric thin film.

The withstand voltage of the thin film capacitor is usually the smallest at the step portions of the dielectric thin film 3, or at the portions of the thin film capacitor 3 covering the right and left edges of the lower electrode.

However, since the step portions at the edges of the thin film capacitor 3 are covered with the second dielectric film 4, the thickness of the dielectric thin film 3 can be readily reduced to about 0.5 μm.

It may be concluded from the discussions above that the capacitors having the constructions shown in Figs. 1 and 2 are useful for the circuits of electronic appliances such as handy-type electronic appliances and microwave telecommunication instruments that require temperature compensation of the circuit. For example, the thin film capacitor according to the present invention can be used in a voltage-controlled oscillator element in combination with a varactor diode.

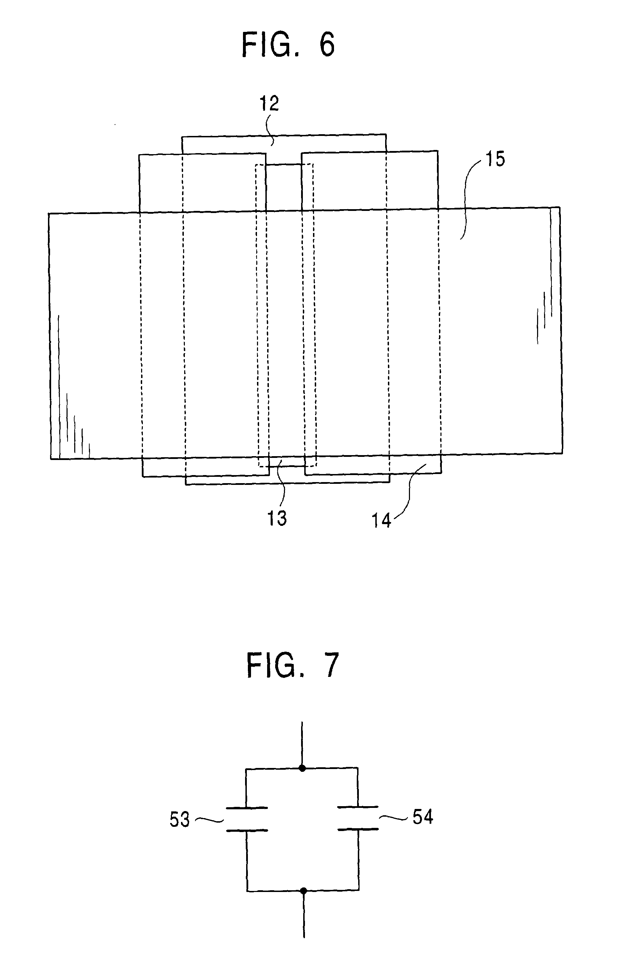

The thin film capacitor according to the second embodiment of the present invention will be described hereinafter with reference to Figs. 5 to 7. The thin film capacitor according to the second embodiment comprises a thin film of a first electrode layer 12 (lower electrode) formed on a substrate 1, and a dielectric thin film 13 laminated at the center on the lower electrode 12. Subsequently, a second dielectric film 14 is laminated so as to cover the both ends of the lower electrode 12 and dielectric thin film 13, followed by laminating a second electrode layer (upper electrode) 15 so as to cover the lower electrode 12, dielectric thin film 13 and second dielectric film 14.

This thin film capacitor differs from the thin film capacitor in the first embodiment in that the dielectric thin film 13 is not provided at each end of the lower electrode 12, and the overlap region between the dielectric thin film 13 and second dielectric film 14 is made to be smaller than the dielectric thin film 13 region and second dielectric film 14 region. Consequently, the temperature coefficient of capacitance can be more freely controlled as compared with the thin film capacitor in the first embodiment.

When the capacitance of the capacitor formed in the dielectric thin film region 13, and the capacitance of the capacitor formed at the second dielectric film 14 region are defined as C13 and C14, the capacitance C of the capacitor formed between the lower electrode 2 and upper electrode 5 is defined by the following equation (III):

$$C = C13 + C14 \quad (III)$$

When the temperature coefficient of capacitance of the dielectric thin film 13 and the temperature coefficient of capacitance of the second dielectric thin film 14 are defined as $\tau 13$ and $\tau 14$, respectively, the temperature coefficient $\tau$ of the total capacitance is represented by the following equation (IV):

$$\tau = [\tau 13\ C13 + \tau 14\ C14]/C \quad (IV)$$

Accordingly, the temperature coefficient of capacitance C can be freely determined by the temperature coefficient $\tau 14$ of capacitance of the second dielectric film 14, and the areas of the dielectric thin film 13 and second dielectric film 14.

Moreover, since the side face of the dielectric thin film 13 is covered with the second dielectric film 14, the thickness of the dielectric thin film 13 may be readily adjusted to about 0.5 μm as in the thin film capacitor according to the first embodiment.

Example

(Example of the thin film capacitor according to the first embodiment)

Each of the lower electrode 2 and the upper electrode 5 was formed into a film thickness of 3 μm using Cu, respectively.

The dielectric thin film 3 was formed into a film thickness of 0.5 μm using $SiO_2$ formed by the sputtering film

deposition method. The $SiO_2$ thin film has a relative dielectric constant of 4.0, a temperature coefficient of capacitance of ±30 ppm/°C, a planar withstand voltage of 500V and a Q-value (at 1GHz) of 500.

The second dielectric film 4 was formed into a film thickness of 1 μm using an acrylic resin. The acrylic resin had a relative dielectric constant of 3.5, a temperature coefficient of capacitance of -2200 ppm/°C, a withstand voltage at the step portion of the lower electrode 2 (step height 3 μm, film thickness 1 μm) of 100V, a Q-value (at 1 GHz) of 100 and a linear thermal expansion coefficient of 210 ppm/°C.

An acrylic polymer material prepared by polymerization of methyl methacrylate and glycidyl methacrylate in a proportion of 19 : 1 was used as the acrylic resin.

A temperature coefficient of capacitance in a range of -2200 ppm/°C to -500 ppm/°C may be obtained in this resin material by changing the proportion of methyl methacrylate and glycidyl methacrylate in the resin in a proportion in a range of 19 : 1 to 1 : 1.

The area ratio x (%) of the dielectric thin film capacitor portion (the capacitor region 51) relative to the second dielectric film capacitor portion (the capacitor region 52) was changed within a range of 40 to 80 in the thin film capacitor in this example, and the temperature coefficient of capacitance and Q-value as shown in Table 1 were obtained.

The thin film capacitor had a withstand voltage of 100V or more in each case.

The size of the facing region between the lower electrode 2 and upper electrode 5 is 300 μm × 300 μm.

TABLE 1

| x(%) | TEMPERATURE COEFFICIENT OF CAPACITANCE (ppm/°C) | Q-VALUE (MEASURING FREQUENCY = 1 GHz) |
|---|---|---|
| 40 | -239 | 315 |
| 50 | -291 | 292 |
| 80 | -432 | 248 |

(Example of fluorinated resin material as second dielectric film 4)

An amorphous fluorinated resin (trade name CYTOP, made by Ashahi Glass Co.) was used as the second dielectric film 4 in place of the acrylic resin material. This amorphous fluorinated resin has a relative dielectric constant of 2.1, a temperature coefficient of capacitance of -1000 ppm/°C, a withstand voltage at the end of the lower electrode 2 (step height 3 μm, film thickness 1 μm) of 100V, a Q-value (at 1 GHz) of 1400 and a linear thermal expansion coefficient of 74 ppm/°C.

The Q-value of the capacitor showed an improvement as compared with the capacitor using the acrylic resin.

The thin film capacitor for temperature compensation according to the present invention comprises a lower electrode formed on a substrate, a dielectric thin film pattern formed on the lower electrode and having a prescribed temperature coefficient of capacitance, a second dielectric film having a temperature coefficient of capacitance being different from the prescribed temperature coefficient of capacitance, and an upper electrode provided at above the dielectric thin film pattern so as to face the lower electrode. The second dielectric film is provided so as to cover the step portion from the edge of the upper face of the dielectric thin film pattern to the side face of the lower electrode, or so as to cover from the edge of the upper face of the dielectric thin film pattern to the side face of the dielectric thin film pattern. The area comprising only the patterned region of the dielectric thin film between the lower electrode and upper electrode, and the area of the overlap region between the dielectric thin film pattern and second dielectric film are adjusted so as to define the temperature coefficient of capacitance.

The capacitor part formed by the region comprising merely the dielectric tin film, and the capacitor part comprising the two layers of the dielectric thin film and second dielectric film are connected in parallel with each other between the lower electrode and upper electrode. In addition, these capacitor portions have different temperature coefficients of capacitance with each other.

Accordingly, a thin film capacitor for temperature compensation having an arbitrary temperature coefficient of capacitance can be readily obtained by determining the temperature coefficient of capacitance by adjusting the areas of the two thin film capacitor regions, without preparing many kinds of dielectric thin film materials. Providing the second dielectric film permits the restriction of the withstand voltage of the dielectric thin film materials to be relaxed.

## Claims

1. A thin film capacitor for temperature compensation comprising a lower electrode formed on a substrate; a dielectric thin film pattern formed on the surface of the lower electrode and having a prescribed temperature coefficient of

capacitance; a second dielectric film having a temperature coefficient of capacitance being different from said prescribed temperature coefficient of capacitance, said second dielectric film being provided so as to cover the step portion from the edge of the upper face of the dielectric thin film pattern to the side face of the lower electrode, or so as to cover from the edge of the upper face of the dielectric thin film pattern to the side face of the film of the dielectric thin film pattern; and an upper electrode provided at above the dielectric thin film pattern so as to face the lower electrode, wherein the temperature coefficient of capacitance is define by adjusting the area of the region comprising only the dielectric thin film pattern between the lower electrode and upper electrode, and the area of the overlap region between the dielectric thin film pattern and second dielectric film

**2.** A thin film capacitor for temperature compensation according to Claim 1, wherein the dielectric thin film has a temperature coefficient of capacitance with an absolute value of 50 ppm/°C or less, and the second dielectric film has a negative temperature coefficient of capacitance with an absolute value of 500 ppm/°C or more.

**3.** A thin film capacitor for temperature compensation according to Claim 2, wherein the second dielectric film has a relative dielectric constant of 4 or less, and a linear thermal expansion coefficient of 50 ppm/°C or more.

**4.** A thin film capacitor for temperature compensation according to Claim 1, wherein the dielectric thin film has a planar withstand voltage of 100V or more, and the second dielectric film has a withstand voltage of 100V or more at both ends of the electrode.

**5.** A thin film capacitor for temperature compensation according to Claim 1, wherein the dielectric thin film has a Q-value of 200 or more, and the second dielectric film has a Q-value of 10 or more at a measuring frequency of 1 GHz or more.

**6.** A thin film capacitor for temperature compensation according to Claim 1, wherein the dielectric thin film comprises $SiO_xN_y$.

**7.** A thin film capacitor for temperature compensation according to Claim 1, wherein the second dielectric film comprises an acrylic resin or a fluorinated resin.

**8.** A thin film capacitor for temperature compensation according to Claim 1, wherein the dielectric thin film comprises $SiO_xN_y$, and the second dielectric film comprises an acrylic resin or a fluorinated resin.

FIG. 1

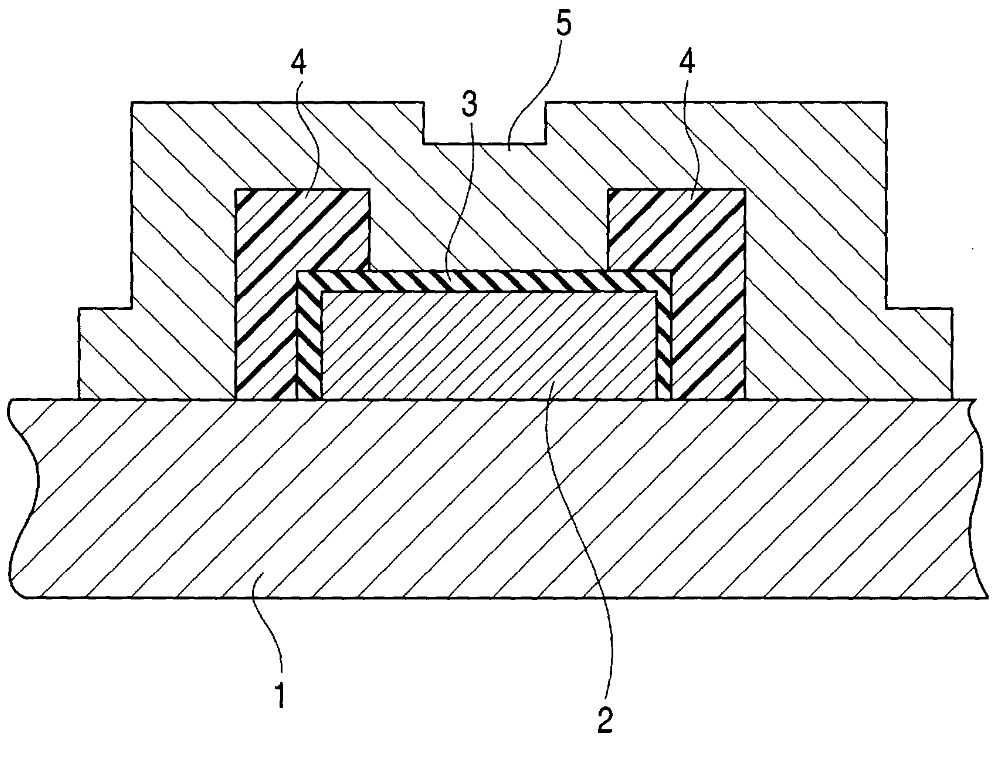

FIG. 2

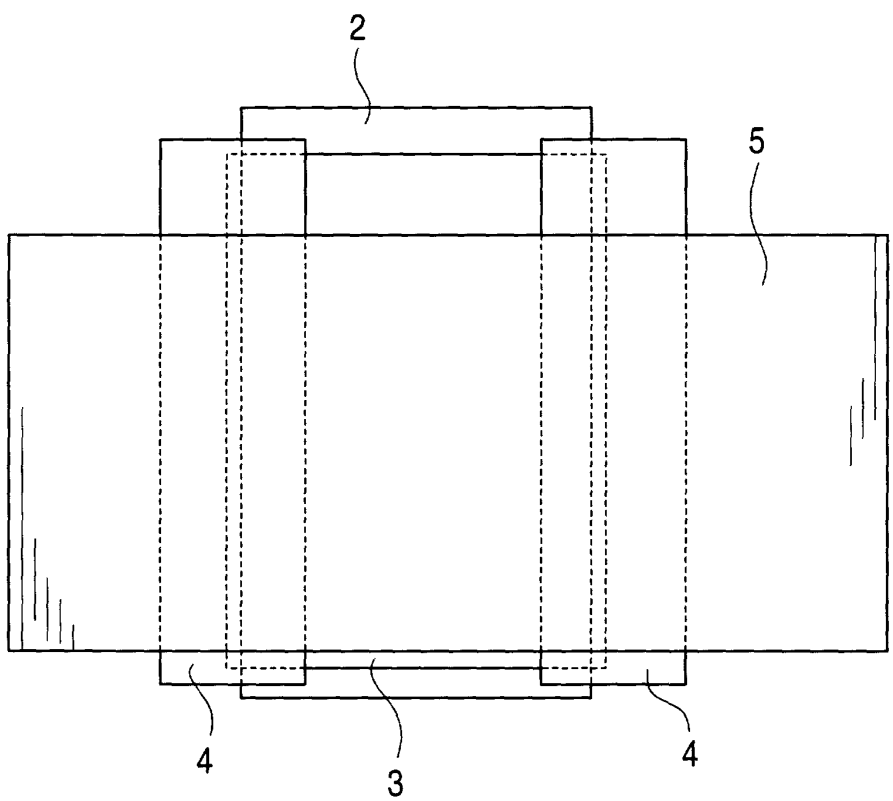

FIG. 3

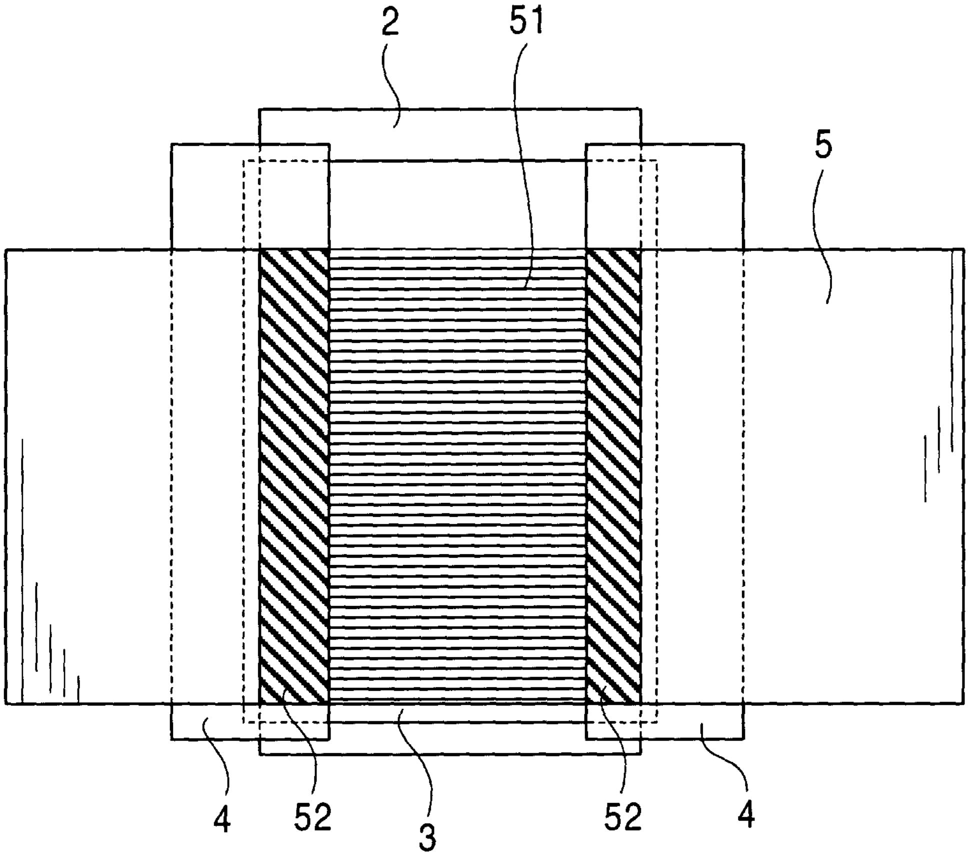


FIG. 4

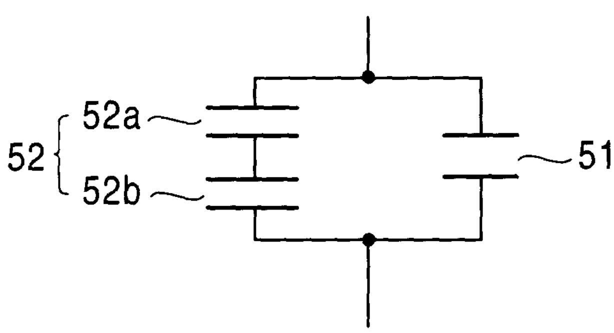

FIG. 5

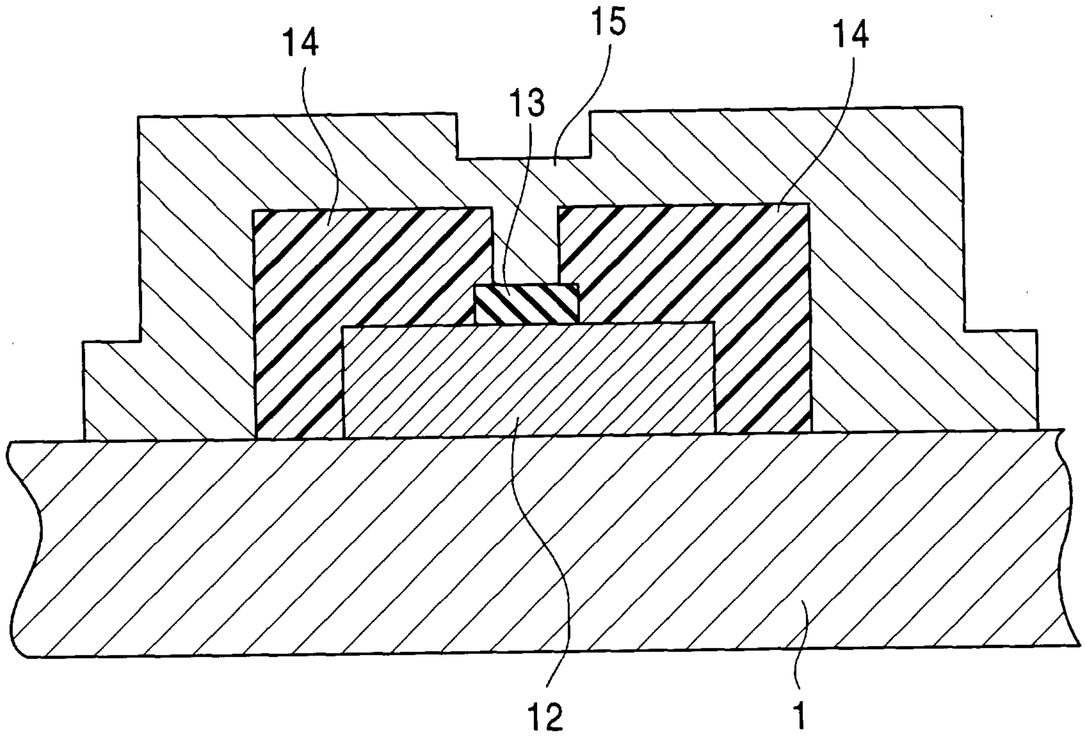

FIG. 6

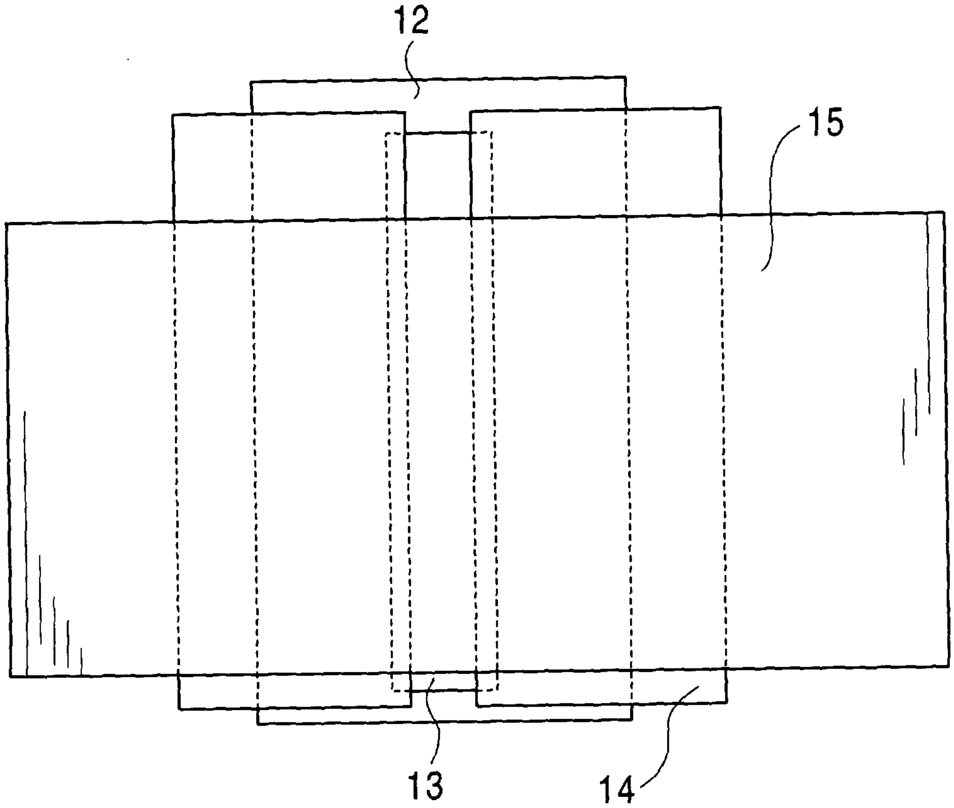


FIG. 7